# EUROPEAN PATENT APPLICATION

(11) **EP 4 432 794 A1**
(43) Date of publication of application: **18.09.2024**
(21) Application number: 22903262.8
(22) Date of filing: 29.11.2022
(51) Int. Cl.: H05K 7/20

(54) **DEVICE NODE AND LIQUID-COOLED CABINET**

(30) Priority: 06.12.2021 CN 202111479105
(71) Applicant: Huawei Technologies Co., Ltd., Shenzhen, Guangdong 518129 (CN)
(72) Inventor: JIA, Hui, Shenzhen, Guangdong 518129 (CN); XIA, Gaoliang, Shenzhen, Guangdong 518129 (CN); LI, Dingfang, Shenzhen, Guangdong 518129 (CN)
(74) Representative: Thun, Clemens
(86) International application number: PCT/CN2022/135017
(87) International publication number: WO 2023/103840

(57) **Abstract**

This application provides a device node and a liquid cooling cabinet, to improve a liquid cooling heat dissipation capability of the device node and meet a heat dissipation requirement of a server. The device node includes a housing, a circuit board, and a heat dissipation component. The housing has a cold liquid inlet and a liquid return outlet. Both the circuit board and the heat dissipation component are disposed in the housing, and at least one main chip is disposed on the circuit board. The heat dissipation component includes a spray plate and at least one liquid cold plate. Each liquid cold plate is configured to form a liquid cooling channel. Liquid cooling channels of all liquid cold plates are communicated to form a liquid cooling network. An inlet of the liquid cooling network is communicated with the cold liquid inlet. The spray plate has a spray channel communicated with an outlet of the liquid cooling network and liquid spray holes communicated with the spray channel, and a liquid outlet end of the liquid spray hole faces the circuit board. The heat dissipation component correspondingly disposed on the device node may perform single-point heat dissipation on the main chip, and may further perform spray heat dissipation on another component on the circuit board, so that the heat dissipation component has a strong single-point heat dissipation capability, and meets a heat dissipation requirement of an existing electronic device.

## Description

### CROSS-REFERENCE TO RELATED APPLICATIONS

This application claims priority to Chinese Patent Application No. 202111479105.6, filed with the China National Intellectual Property Administration on December 6, 2021 and entitled "DEVICE NODE AND LIQUID COOLING CABINET", which is incorporated herein by reference in its entirety.

### TECHNICAL FIELD

This application relates to the field of video surveillance technologies, and in particular, to a device node and a liquid cooling cabinet.

### BACKGROUND

With development of technologies, power of electronic devices such as a server is increasingly high, and a higher requirement is also imposed on heat dissipation of the electronic devices. Because conventional air-cooled heat dissipation increases energy consumption for server cooling, liquid cooling heat dissipation may be used. Specifically, a liquid cooling cabinet usually dissipates heat for a device node through immersion heat dissipation or spray heat dissipation. The immersion heat dissipation has a high requirement on a pressure resistance capability of a device, and increases structural design difficulty. However, in a spray heat dissipation manner, traffic at a position of a main chip on the device node is limited, and a heat dissipation capability is insufficient.

It can be learned that there is a defect in a design of an existing liquid cooling heat dissipation structure, and a heat dissipation capability of the existing liquid cooling heat dissipation structure is insufficient to meet a heat dissipation requirement.

### SUMMARY

This application provides a device node and a liquid cooling cabinet, to improve a liquid cooling heat dissipation capability of the device node and meet a heat dissipation requirement of a server.

According to a first aspect, this application provides a device node. The device node includes a housing, a circuit board, and a heat dissipation component. The housing has a cavity, and a cold liquid inlet and a liquid return outlet are disposed on the housing. Both the circuit board and the heat dissipation component are disposed in the housing, and at least one main chip is disposed on the circuit board. The main chip generates more heat when operating, and heat generated by another component on the circuit board is less than that generated by the main chip. Therefore, the heat dissipation component uses different heat dissipation structures to dissipate heat for the main chip and the circuit board. Specifically, the heat dissipation component includes a spray plate and at least one liquid cold plate, where the at least one liquid cold plate is in a one-to-one correspondence with the at least one main chip, and each liquid cold plate is in contact with a corresponding main chip to perform liquid cooling heat dissipation for the corresponding main chip. Each liquid cold plate is configured to form a liquid cooling channel. Liquid cooling channels of the at least one liquid cold plate are communicated to form a liquid cooling network. An inlet of the liquid cooling network is communicated with a cold liquid inlet of the housing. External coolant enters the housing from the cold liquid inlet and directly leads into each liquid cooling channel in the liquid cooling network, so that single-point liquid cooling heat dissipation may be performed on the main chip. The spray plate has a spray channel communicated with an outlet of the liquid cooling network and a plurality of liquid spray holes communicated with the spray channel. A liquid outlet end of each of the liquid spray holes faces the circuit board. After entering the spray channel from the liquid cooling channel, the coolant is sprayed onto the circuit board through the liquid spray hole, to perform spray heat dissipation on another component on the circuit board.

The heat dissipation component correspondingly disposed on the device node may perform single-point heat dissipation on the at least one main chip, and may further perform spray heat dissipation on another component on the circuit board other than the main chip, to improve a single-point heat dissipation capability of liquid cooling heat dissipation, and meet a heat dissipation requirement of a current electronic device.

To facilitate the coolant flowing out of the housing, the liquid return outlet is disposed at a lowest position in space inside the housing, and coolant in an inner cavity of the housing may accumulate to a side of the liquid return outlet under a gravity action and flow out of the liquid return outlet.

A surface that is of the spray plate and that faces the circuit board includes a first area and a second area. The first area and the second area do not overlap, the first area corresponds to the at least one main chip, and the liquid spray hole is specifically located in the second area, so that an orthographic projection of the at least one main chip on the spray plate does not overlap with a position of the liquid spray hole, and coolant in the spray plate does not need to be sprayed onto the main chip. This saves flow.

When coolant flows into the device node, the coolant falls into the housing after passing through the liquid cold plate and the spray plate. A liquid level of the coolant in the housing needs to be 1 mm to 3 mm higher than a highest position on a surface of the circuit board, so that the coolant can immerse most components on the circuit board to perform liquid cooling heat dissipation, and the coolant can also be saved.

The liquid cooling channels of the at least one liquid cold plate may be communicated to form the liquid cooling network, and may be communicated in a series and/or parallel connection structure.

A structure of the liquid cold plate may be implemented in a plurality of manners. For example, the liquid cold plate includes a plate shell fastened to the main chip, and the plate shell has a hollow cavity to form the liquid cooling channel. Alternatively, the liquid cold plate includes a plate body fastened to the circuit board, and the liquid cooling channel is formed between the plate body and the circuit board, where the liquid cooling channel includes a first liquid cooling cavity communicated with the cold liquid inlet and a second liquid cooling cavity communicated with the spray channel, the main chip is located in the second liquid cooling cavity, a jet plate is disposed between the first liquid cooling cavity and the second liquid cooling cavity, the jet plate has a jet hole that connects the first liquid cooling cavity and the second liquid cooling cavity, and the jet hole is configured to spray coolant in the first liquid cooling cavity to the main chip.

According to a second aspect, this application provides a liquid cooling cabinet. The liquid cooling cabinet may include a cabinet body, a circulation liquid cooling system, and at least one of the foregoing device nodes. The at least one device node may be inserted into the cabinet body in a vertical direction of the cabinet body. The circulation liquid cooling system may be communicated with a cold liquid inlet of each device node through a liquid supply pipe. The circulation liquid cooling system is sealedly communicated with a liquid return outlet of each device node through a liquid return pipe. An air intake vent communicated with an atmosphere is further disposed on a top of the liquid return pipe, so that the liquid return pipe keeps in a normal pressure state, and the coolant in each device node can flow into the liquid return pipe.

The circulation liquid cooling system specifically includes a liquid storage tank and a heat exchange unit. The liquid storage tank is disposed in the cabinet body and is located at the bottom of the cabinet body, and the heat exchange unit is integrated behind the cabinet body, so that the liquid storage tank, the heat exchange unit, and the cabinet body are integrated, thereby ensuring that a volume of the liquid cooling cabinet meets a design requirement. The liquid storage tank has a liquid return inlet and a cold liquid outlet. The liquid return inlet is communicated with the liquid return pipe, the cold liquid outlet is communicated with the liquid supply pipe, and the heat exchange unit is connected between the cold liquid outlet and the liquid supply pipe to cool coolant in the liquid supply pipe.

The heat exchange unit includes a control board, a heat exchanger, and a circulation pump group, and the control board is signally communicated with the circulation pump group. A liquid inlet of the heat exchanger is communicated with a liquid return outlet, a liquid outlet of the heat exchanger is communicated with the liquid supply pipe, the heat exchanger is connected to an external cooling water source, the external cooling water source enters the heat exchanger, and cools the coolant by exchanging heat with coolant in the heat exchanger. The circulation pump group is disposed between the liquid return outlet and the liquid inlet, and is configured to press coolant pump in the liquid storage tank into the liquid supply pipe. The control board can control operation of the circulation pump group.

The liquid storage tank has a liquid storage cavity and an operating cavity that are separated. Both the liquid return inlet and the cold liquid outlet are communicated with the operating cavity, and the operating cavity is equivalent to participating in an operating process of the circulation liquid cooling system. A liquid-through channel is formed between the liquid storage cavity and the operating cavity. When there is too much coolant in the operating cavity, the coolant may enter the liquid storage cavity through the liquid-through channel for storage. When the coolant in the operating cavity is insufficient for maintaining liquid cooling circulation, the coolant in the liquid storage cavity may be supplemented to the operating cavity.

In a possible implementation, a partition plate is disposed in the liquid storage tank, the partition plate separates the liquid storage tank into the liquid storage cavity and the operating cavity, a gap exists between a top of the partition plate and an inner wall of the liquid storage tank to form the liquid-through channel. When there is excessive coolant in the operating cavity, the coolant overflows from the top of the partition plate to the liquid storage cavity. The liquid storage cavity is communicated with the operating cavity through a liquid refill pipe. When the coolant in the operating cavity is insufficient, the coolant in the liquid storage cavity may flow to the operating cavity through the liquid refill pipe. Specifically, a liquid refill pump configured to drive the coolant from the liquid storage cavity to flow to the operating cavity is disposed on the liquid refill pipe, and the liquid refill pump is signally connected to the control board in the heat exchange unit.

To monitor a liquid level of the coolant in the liquid storage cavity, a first liquid level sensor is disposed in the liquid storage cavity, and the first liquid level sensor has an alarm. When the liquid level of the coolant in the liquid storage cavity is lower than a specified liquid level, the first liquid level sensor triggers the alarm, and notifies a worker to add the coolant to the liquid storage tank in time.

To monitor a liquid level of the coolant in the operating cavity, a second liquid level sensor is disposed in the operating cavity. The second liquid level sensor is signally connected to a control board of the heat exchange unit. The control board receives liquid level information monitored by the second liquid level sensor, and controls, based on the liquid level information, the liquid refill pump to press coolant pump in the liquid storage cavity to the operating cavity, so that the liquid level of the coolant in the operating cavity is restored to a normal operating liquid level.

To implement targeted heat dissipation for each device node, at least one liquid supply port is formed on the liquid supply pipe. Each liquid supply port is configured to correspondingly connect to a cold liquid inlet of one device node. The liquid supply port is communicated with the cold liquid inlet through a quick connector, to facilitate insertion and removal of the device node.

Correspondingly, at least one liquid return port is formed on the liquid return pipe, and each liquid return port is configured to be correspondingly communicated with a liquid return outlet of one device node. In a liquid return port and a liquid return outlet that are in a group and that correspond to each other, an inner diameter of the liquid return port is greater than an outer diameter of the liquid return outlet, so that the liquid return outlet is inserted into the liquid return port. An elastic backflow prevention component is disposed on the liquid return port, and when the liquid return outlet is inserted into the liquid return port, the backflow prevention component is abutted with an outer wall of the liquid return outlet. When the liquid return outlet is separated from the liquid return port, the backflow prevention component blocks the liquid return port in a radial direction. This can provide a period of time for the coolant in the device node to flow back to the liquid return pipe. After the device node is separated from the liquid supply port and placed for a period of time, the coolant in the device node flows into the liquid return pipe completely. Then, the device node is pulled out completely for maintenance. The backflow prevention component may be made of an elastic material (for example, rubber), and meets requirements of radial sealing and a plurality of times of insertion and removal.

For each device node, the housing has a first end and a second end that are opposite to each other, the liquid return outlet is disposed at the second end, and a horizontal plane on which the first end is located is adjusted to be higher than a horizontal plane on which the second end is located, so that coolant in the device node flows out. Possibly, the cabinet body may be adjusted, so that the device node generates the foregoing tilt effect with a change of a cabinet structure. A first foot corresponding to the first end and a second foot corresponding to the second end may be disposed at a bottom of the cabinet body, and a height of the first foot is set to be greater than a height of the second foot.

### BRIEF DESCRIPTION OF DRAWINGS

FIG. 1 is a diagram of a structure of a device node according to an embodiment of this application;
FIG. 2a to FIG. 2d are diagrams of an internal structure of a device node according to an embodiment of this application;
FIG. 3a and FIG. 3b are diagrams of a cross-sectional structure of a liquid cold plate in a device node according to an embodiment of this application;
FIG. 3c is a diagram of a structure of a spray plate in a device node according to an embodiment of this application;
FIG. 4a is a diagram of a structure of a liquid cooling cabinet according to an embodiment of this application;
FIG. 4b is a diagram of an internal structure of a cabinet body in a liquid cooling cabinet according to an embodiment of this application;
FIG. 5 is a diagram of a structure of a liquid storage tank in a liquid cooling cabinet according to an embodiment of this application;
FIG. 6 is a diagram of a structure of cooperation between a liquid storage tank and a heat exchange unit in a liquid cooling cabinet according to an embodiment of this application;
FIG. 7 is a diagram of an internal structure of a liquid cooling cabinet according to an embodiment of this application;
FIG. 8 is a diagram of a structure in which a device node in a liquid cooling cabinet is obliquely disposed relative to a cabinet body according to an embodiment of this application;
FIG. 9 is a diagram of a structure in which a cabinet body in a liquid cooling cabinet is obliquely disposed relative to a horizontal plane according to an embodiment of this application;
FIG. 10a and FIG. 10b are diagrams of a structure of a connection between a device node, a liquid supply pipe, and a liquid return pipe in a liquid cooling cabinet according to an embodiment of this application;
FIG. 11 is a diagram of a structure of a quick connector used between a cold liquid inlet of a device node in a liquid cooling cabinet and a liquid supply port of a liquid supply pipe according to an embodiment of this application;
FIG. 12a and FIG. 12b are diagrams of a structure of a connection between a liquid return outlet of a device node in a liquid cooling cabinet and a liquid return port of a liquid return pipe according to an embodiment of this application;
FIG. 13a and FIG. 13b are diagrams of a structure of a backflow prevention component on a liquid return port in a liquid cooling cabinet according to an embodiment of this application;
FIG. 14 is a diagram of a structure of a connection between a device node and a cabinet in a liquid cooling cabinet according to an embodiment of this application;
FIG. 15a is a diagram of a structure of a device node in a liquid cooling cabinet before being mounted in a cabinet according to an embodiment of this application; and
FIG. 15b is a diagram of a structure in which a device node in a liquid cooling cabinet is mounted in a cabinet according to an embodiment of this application.

### DESCRIPTION OF EMBODIMENTS

A liquid cooling cabinet may dissipate heat for an electronic device in a liquid cooling manner. A current liquid cooling cabinet may dissipate heat for a device node of the electronic device in an immersion or spray manner. The immersion heat dissipation has a high requirement on a pressure resistance capability of a device, and increases structural design difficulty. However, in a spray heat dissipation manner, traffic at a position of a main chip on the device node is limited, and a heat dissipation capability is insufficient.

Based on this, embodiments of this application provide a device node and a liquid cooling cabinet, to resolve the foregoing problem. To make the objectives, technical solutions, and advantages of this application clearer, the following further describes this application in detail with reference to the accompanying drawings.

Terms used in the following embodiments are merely intended to describe specific embodiments, but are not intended to limit this application. As used in the specification of this application and the appended claims, the singular expression "a", "an", "the", "the foregoing", "such a", or "this" is intended to also include an expression "one or more" unless otherwise clearly indicated in the context.

Reference to "an embodiment", "some embodiments", or the like described in the specification indicates that one or more embodiments of this application include a specific feature, structure, or characteristic described with reference to embodiments. Therefore, statements such as "in an embodiment", "in some embodiments", "in some other embodiments", and " in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

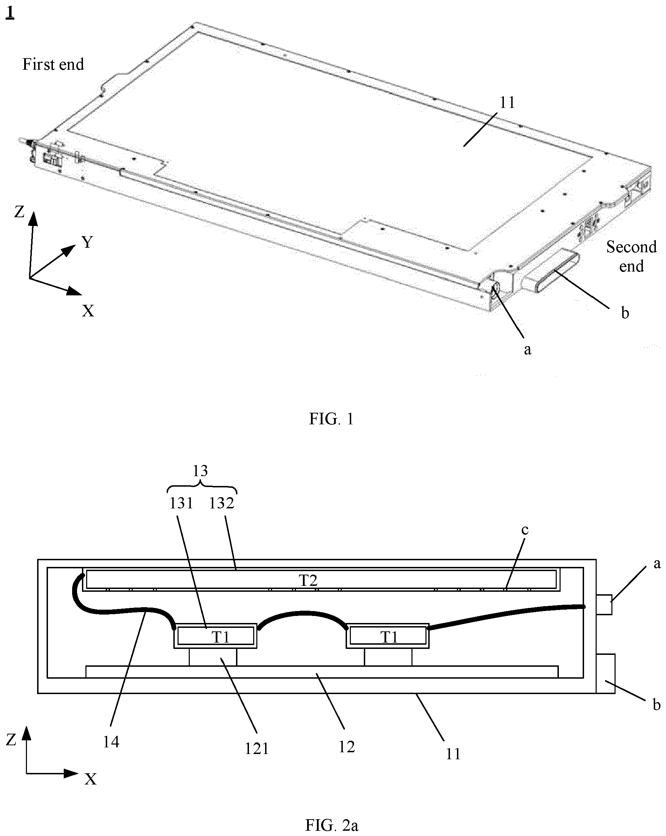

Refer to FIG. 1. An embodiment of this application provides a device node 1. The device node 1 includes a housing 11, the housing 11 has a cavity, and a cold liquid inlet a for coolant inflow and a liquid return outlet b for coolant outflow are disposed on the housing 11. Externally insulated coolant may enter the housing 11 of the device from the cold liquid inlet a, and coolant in the housing 11 may flow out through the liquid return outlet b. A structure of the device node 1 shown in FIG. 1 is used as an example. It is specified that the housing 11 has a first end and a second end that are opposite to each other in a first direction, and the first direction is specified as X. A thickness direction of the housing 11 is specified as a third direction Y, and a direction perpendicular to the first direction X and the third direction Z is specified as a second direction Y. Both the cold liquid inlet a and the liquid return outlet b of the housing 11 are located at the second end.

FIG. 2a is a diagram of an internal structure of the device node 1. The device node 1 further includes a circuit board 12 and a heat dissipation component 13. Both the circuit board 12 and the heat dissipation component 13 are disposed in the cavity of the housing 11. The housing 11 provides mounting space and bearing support for the circuit board 12 and the heat dissipation component 13. The circuit board 12 is located at a bottom of the housing 11 relatively. The bottom is a relative position, and refers to a bottom in a state shown in FIG. 2a. At least one main chip 121 is disposed on the circuit board 12. The main chip 121 has high power consumption and can generate high heat, and the main chip 121 may be defined as a first-type device. Theoretically, another device with low power consumption and less heat generation is further disposed on the circuit board 12, and this type of device may be defined as a second-type device. For the first-type device and the second-type device, the heat dissipation component 13 provided in embodiments of this application uses different heat dissipation manners.

Specifically, the heat dissipation component 13 includes a spray plate 132 and at least one liquid cold plate 131. The at least one liquid cold plate 131 is in a one-to-one correspondence with the at least one main chip 121. Each liquid cold plate 131 is configured to correspondingly be in contact with one main chip 121 to perform liquid cooling heat dissipation on the main chip 121. Each liquid cold plate 131 may be configured to form a liquid cooling channel T1 through which coolant passes. In FIG. 2a, each main chip 121 corresponds to one liquid cold plate 131. When the coolant flows through the liquid cooling channel T1 corresponding to each liquid cold plate 131, targeted liquid cooling heat dissipation may be performed on each main chip 121. Herein, there is at least one liquid cold plate 131. Liquid cooling channels T1 corresponding to all liquid cold plates 131 may form a liquid cooling network. The liquid cooling network has an inlet and an outlet. After entering from the inlet of the liquid cooling network, coolant flows into the liquid cooling channel T1 of each liquid cold plate 131, and coolant flowing out of the liquid cooling channel T1 corresponding to each liquid cold plate 131 flows out of the outlet of the liquid cooling network. Herein, the inlet of the liquid cooling network may be directly communicated with the foregoing cold liquid inlet a, so that the coolant directly enters each liquid cooling channel T1 in the liquid cooling network from the cold liquid inlet a to perform liquid cooling heat dissipation for each main chip 121.

The spray plate 132 has a spray channel T2 and a plurality of liquid spray holes c communicated with the spray channel T2, and a liquid outlet end of each liquid spray hole c faces the circuit board 12. An inlet of the spray channel T2 is directly communicated with the outlet of the liquid cooling network. After completing liquid cooling heat dissipation of the main chip 121, the coolant enters the spray channel T2 to perform spray heat dissipation on another structure on the circuit board 12. The spray plate 132 is specifically located on a top of the housing 1, so that the coolant in the spray channel T2 may be sprayed onto the circuit board 12 through the liquid spray holes c under gravity action.

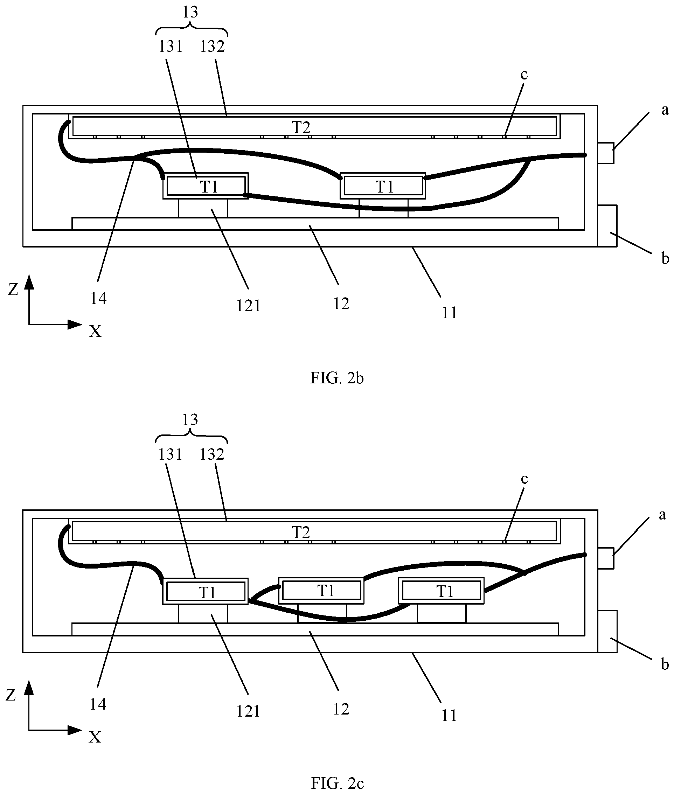

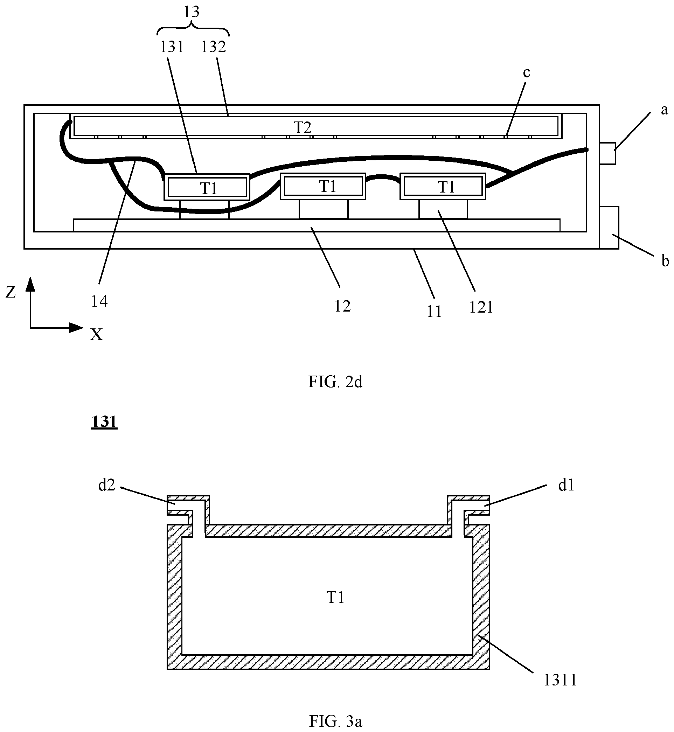

When there is more than one liquid cold plate 131 (two liquid cold plates are shown herein), the liquid cold plates 131 may be disposed in series (as shown in FIG. 2a), in other words, liquid cooling channels T1 corresponding to the liquid cold plates 131 are sequentially connected from head to tail. An inlet of the liquid cooling channel T1 at a head end is equivalent to the inlet of the liquid cooling network, and the inlet of the liquid cooling channel T1 is directly communicated with the cold liquid inlet a. An outlet of the liquid cooling channel T1 at a tail end is equivalent to the outlet of the liquid cooling network, and the outlet of the liquid cooling channel T1 is directly communicated with an inlet of the spray channel T2. Coolant entering from the inlet of the liquid cooling network is equivalent to entering the liquid cooling channels T1 in sequence to perform liquid cooling heat dissipation on the main chips 121 in sequence. Alternatively, the liquid cold plates 131 may be disposed in parallel (as shown in FIG. 2b), in other words, inlets of liquid cooling channels T1 corresponding to the liquid cold plates 131 converge as one inlet, where the inlet is equivalent to the inlet of the liquid cooling network to directly communicate with the cold liquid inlet a, and the liquid cooling channels T1 corresponding to the liquid cold plates 131 converge as one outlet, where the outlet is equivalent to the outlet of the liquid cooling network to directly communicate with the inlet of the spray channel T2. The liquid cooling channels T1 are equivalently disposed in parallel, and the coolant entering from the inlet of the liquid cooling network is equivalent to entering the liquid cooling channels T1 in a plurality of paths, to perform liquid cooling heat dissipation on the main chips 121 at the same time. When there is more than one liquid cold plate 131 (three liquid cold plates are shown herein), the liquid cold plates 131 may be disposed in a series-parallel mixed manner, in other words, two liquid cold plates 131 are connected in parallel, and the two liquid cold plates 131 connected in parallel are connected in series to another liquid cold plate 131 (as shown in FIG. 2c). Alternatively, two liquid cold plates 131 are connected in series, and the two liquid cold plates 131 connected in series are connected in parallel to another liquid cold plate 131 (as shown in FIG. 2d). Certainly, when there are more than three liquid cold plates 131, the liquid cooling network formed by the liquid cooling channels T1 of the liquid cold plates 131 may be deformed in more connection manners. Examples are not described herein.

Liquid cooling channels T1 of adj acent liquid cold plates 131, and the liquid cooling channel T1 and the spray channel T2 may be communicated through a hose 14.

In FIG. 2a to FIG. 2d, the coolant that enters the housing 11 from the cold liquid inlet a first enters the liquid cooling channels T1 (which may be in the serial connection manner shown in FIG. 2a or the parallel connection manner shown in FIG. 2b) of the liquid cold plates 131, to perform liquid cooling heat dissipation on the first-type device (for example, the main chip 121), then enters a spray channel of the spray plate 132, and is sprayed onto the circuit board 12 through the liquid spray hole c, so that spray heat dissipation may be performed on the second-type device on the circuit board 12. After spraying the second-type device on the circuit board 12, the coolant falls into the housing 11, and is discharged through the liquid return outlet b.

To facilitate the coolant of the housing 11 flowing out of the liquid return outlet b, the liquid return outlet b may be disposed at a low position of the housing 11. Specifically, the liquid return outlet b may be disposed at a lowest position of the housing 11. The lowest position herein refers to a horizontal plane on which a lowest position of space occupied by an inner cavity formed by the housing 11 is located. The structure of the device node 1 shown in FIG. 1 is used as an example. The liquid return outlet b is disposed at the second end, and a fixed state of the housing 11 is adjusted, so that a horizontal plane on which the first end is located is higher than a horizontal plane on which the second end is located. In this case, the coolant in the housing 11 may accumulate from the first end to the second end under the gravity action, so that the coolant is discharged from the liquid return outlet b.

For specific structures of the liquid cold plates 131 shown in FIG. 2a to FIG. 2d, refer to FIG. 3a. The liquid cold plate 131 includes a plate shell 1311, where the plate shell 1311 is a shell structure and has a cavity, and the cavity may form the liquid cooling channel T1. The plate shell 1311 may be directly fastened to the main chip 121 through bonding or the like, and heat exchange between the coolant and the main chip 121 is implemented by using the plate shell 1311. To facilitate liquid inlet and outlet of the liquid cooling channel T 1, a liquid inlet nozzle d1 and a liquid outlet nozzle d2 may be disposed on the plate shell 1311. Positions and shapes of the liquid inlet nozzle d1 and the liquid outlet nozzle d2 are not limited. The liquid inlet nozzle d1 is configured to allow the coolant to enter the cavity of the plate shell 1311, and the liquid outlet nozzle d2 is configured to allow the coolant to flow out of the cavity of the plate shell 1311. In an ideal state, the cavity of the plate shell 1311 should be in a state of being filled with coolant, to perform full cold and hot exchange with the main chip 121, and implement liquid cooling heat dissipation for the main chip 121.

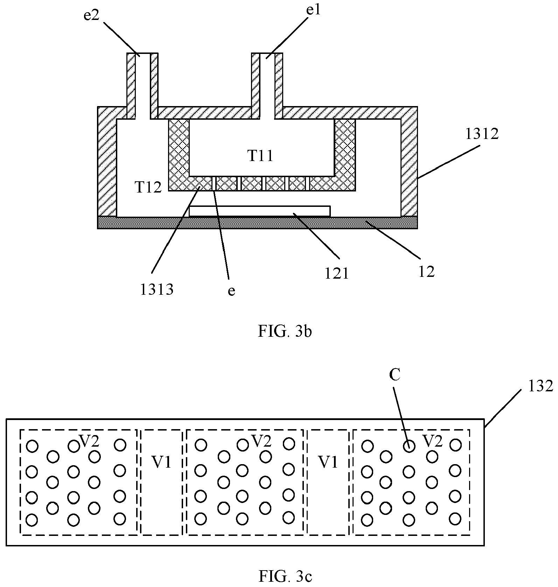

In another embodiment, for a structure of a liquid cold plate 131, refer to FIG. 3b. The liquid cold plate 131 includes a plate body 1312, where the plate body 1312 is fastened to a circuit board 12, and the foregoing liquid cooling channel T1 is formed between the plate body 1312 and the circuit board 12. A liquid inlet nozzle e1 and a liquid outlet nozzle e2 are disposed on the plate body 1312. Specifically, the liquid cooling channel T1 includes a first liquid cooling cavity T11 communicated with the liquid inlet nozzle e1 and a second liquid cooling cavity T12 communicated with the liquid outlet nozzle e2. The main chip 121 is located in the second liquid cooling cavity T12. When the second liquid cooling cavity T 12 is filled with coolant, it is equivalent to that the main chip 121 is immersed in the coolant. A jet plate 1313 is disposed between the first liquid cooling cavity T11 and the second liquid cooling cavity T12, and the jet plate 1313 has a jet hole w that connects the first liquid cooling cavity T11 and the second liquid cooling cavity T12. The jet hole w is configured to spray the coolant in the first liquid cooling cavity T11 to the main chip 121. The coolant directly impacts a surface of the main chip 121, and no thermally conductive interface material is required, so that a liquid cooling heat dissipation effect can be improved. In this embodiment, the liquid cold plate 131 is in direct contact with the main chip 121 by using coolant to perform liquid cooling heat dissipation for the main chip 121, and the liquid cooling channel T1 is formed by cooperating the plate body 1312 and the circuit board 12. The "cooperation" herein refers to that the liquid cooling channel T1 is formed by fastening the plate body 1312 and the circuit board 12 together through a structural design.

FIG. 3c shows a surface of the spray plate 132 facing the circuit board 12. The surface of the spray plate 132 facing the circuit board 12 is divided into at least a first area V1 and a second area V2. The first area V1 and the second area V2 do not overlap. The first area V1 corresponds to all the main chips 121. The liquid spray hole c is disposed in the second area V2, an orthographic projection (projected to the spray plate 132 in a direction perpendicular to the spray plate 132) of each main chip 121 on the spray plate 132 does not overlap with a position of the spray hole c. Coolant in the spray plate 132 is mainly used to perform spray heat dissipation for another component on the circuit board 12 other than the main chip 121. Such a disposing manner helps save a flow of the coolant. Herein, shapes and distribution directions of a plurality of spray holes c are not limited, and FIG. 3c is merely an example.

It should be noted that, when the coolant flows into the device node 1, the coolant falls into the housing 11 after passing through the liquid cold plate 131 and the spray plate 132. A liquid level of the coolant in the housing 11 needs to be 1 mm to 3 mm higher than a highest position on the surface of the circuit board 12, so that the coolant can immerse most components on the circuit board 12 to perform liquid cooling heat dissipation, and the coolant can also be saved. It can be learned that a heat dissipation component 13 is correspondingly disposed on the device node 1 provided in this embodiment of this application. The liquid cold plate 131 in the heat dissipation component 13 may perform targeted liquid cooling heat dissipation on a component, like the main chip 121, that has high power consumption and high heat in the device node 1. The spray plate 132 may perform spray heat dissipation on another component that has low power consumption and low heat on the circuit board 12, so that a single-point heat dissipation capability can be improved while liquid cooling heat dissipation is implemented, and a heat dissipation requirement of a current electronic device is met.

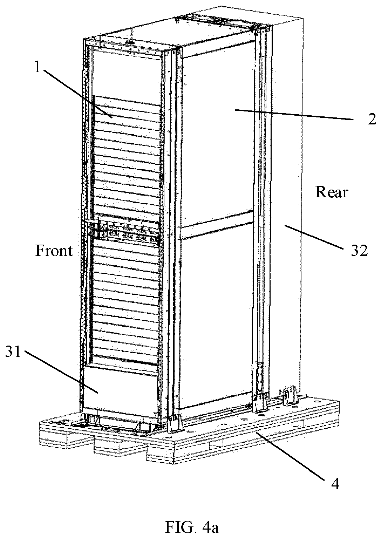

Based on the foregoing device node 1, an embodiment of this application further provides a liquid cooling cabinet. For a structure of the liquid cooling cabinet, refer to FIG. 4a. The liquid cooling cabinet specifically includes a cabinet body 2, and at least one device node 1 may be mounted in the cabinet body 2. The device node 1 is equivalent to any minimum pluggable unit in the liquid cooling cabinet, and the cabinet body 2 is configured to carry the device node.

The liquid cooling cabinet further includes a circulation liquid cooling system that provides coolant for the device node 1 in a circulation manner. The circulation liquid cooling system specifically includes a liquid storage tank 31 and a heat exchange unit 32. The liquid storage tank 31 is configured to store coolant, provides coolant for each device node 1, and recycles coolant flowing out of the device node 1. The liquid storage tank 31 is disposed in the cabinet body 2 and is located at a bottom of the cabinet body 2, so that the coolant flowing out of the device node 1 flows into the liquid storage tank 31 under a gravity action. The heat exchange unit 32 is integrated at the rear of the cabinet body 2, and the heat exchange unit 32 is configured to cool coolant transported to a device node 2 to reduce a temperature of the coolant, to perform good cooling and heat dissipation for the device node 1. The rear is specified with reference to that the liquid cooling cabinet faces an operation plane of a staff, and the operation plane of the liquid cooling cabinet is specified as the front, and the other side corresponding to the front is specified as the rear. Refer to FIG. 4a. A front end and a rear end of the cabinet body 2 are defined. The heat exchange unit 32 may be disposed at a position of a rear door of the cabinet body 2, so that a size of the liquid cooling cabinet is not increased, and a size requirement of a standard cabinet is met. In this embodiment, the liquid storage tank 31, the heat exchange unit 32, and the cabinet body 2 may be integrated together, and a base 4 is disposed at a bottom of an overall structure of the cabinet body 2 and the heat exchange unit 32, to facilitate placement and movement of the overall structure of the liquid cooling cabinet.

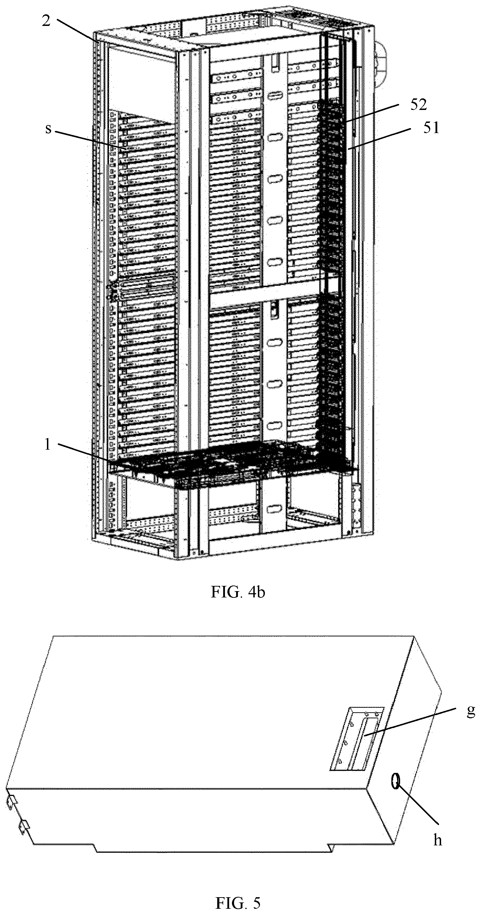

For a structure of the cabinet body 2, refer to FIG. 4b. A plurality of mounting stations s may be disposed in the cabinet body 2. Each mounting station s has a chute, and may be correspondingly inserted with one of the foregoing device nodes 1. Each device node 1 may be inserted into the mounting station s and connected to the cabinet body 2 through various connectors in the cabinet body 2. The connections herein include electricity, a signal, and coolant. A manner of arranging the device nodes 1 in the cabinet body 2 may not be limited. In FIG. 4a and FIG. 4b, a plurality of device nodes 1 are sequentially arranged along a height direction of the cabinet body 2. Each device node 2 has a determined height, but a distance between adjacent device nodes 2 may not be limited. The circulation liquid cooling system is connected to a cold liquid inlet a of each device node 1 through a liquid supply pipe 51, to provide coolant for the heat dissipation component 13 in the device node 1. In addition, the circulation liquid cooling system is in closed communication with a liquid return outlet b of each device node 1 through a liquid return pipe 52, to recover the coolant in the device node 1. The liquid supply pipe 51 and the liquid return pipe 52 are both disposed in the cabinet body 2.

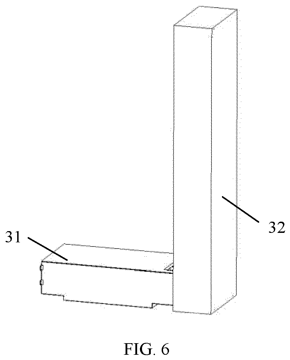

For a structure of the liquid storage tank 31, refer to FIG. 5. The liquid storage tank 31 is a shell structure, and has an inner cavity that can hold coolant, and has a liquid return inlet g and a cold liquid outlet h. The liquid return inlet g is specifically located at a top position of the liquid storage tank 31, so that the coolant flowing out of the device node 2 enters the liquid storage tank 31 from the liquid return inlet g. With reference to a position structure of the liquid storage tank 31 and the heat exchange unit 32 shown in FIG. 6, a cold liquid outlet h of the liquid storage tank 31 is disposed on a side surface that is of the liquid storage tank 31 and that is configured to interconnect with the heat exchange unit 32, and coolant in the liquid storage tank 31 enters the heat exchange unit 32 from the cold liquid outlet h.

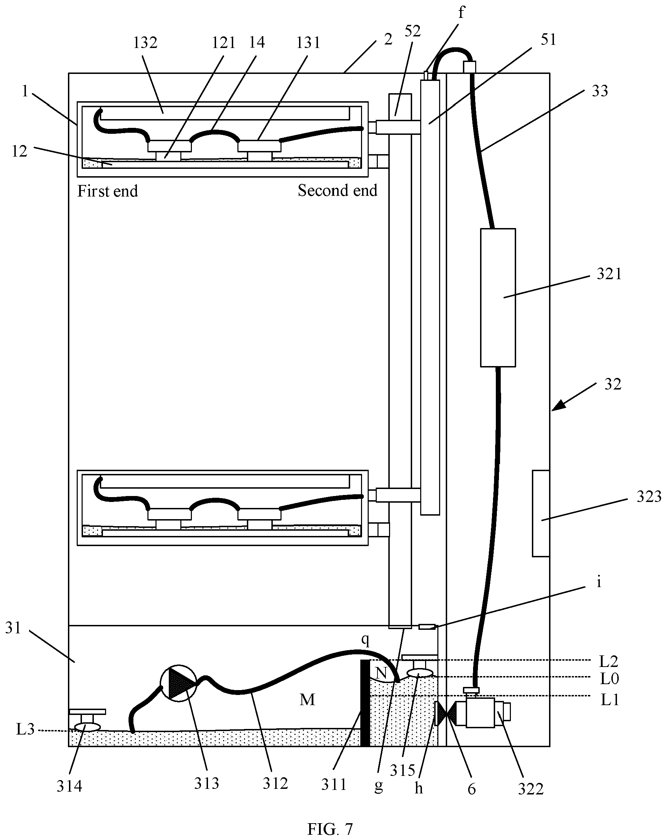

FIG. 7 is a simplified structural diagram of an internal structure of a liquid cooling cabinet. Two device nodes 1 are mounted in a cabinet body 2 for example, and the two device nodes 1 are stacked in a vertical direction in the cabinet body 2. The circulation liquid cooling system is communicated with a cold liquid inlet a of each device node 1 through a liquid supply pipe 51, to provide coolant for the heat dissipation component 13 in the device node 1. In addition, the circulation liquid cooling system is in closed communication with a liquid return outlet b of each device node 1 through a liquid return pipe 52, to recover the coolant in the device node 1. An air intake vent f communicated with an atmosphere is provided on a top of the liquid return pipe 52. The air intake vent f can ensure that a normal pressure is maintained in the liquid return pipe 52. Coolant in the liquid return pipe 52 may enter the liquid storage tank 31 under a gravity action through a liquid return inlet g of the liquid storage tank 31, and no additional power source is required, thereby saving costs. Herein, a liquid filling inlet i is further disposed on the top of the liquid storage tank 31. When the coolant inside the liquid storage tank 31 is insufficient, coolant is added to the liquid storage tank 31 through the liquid filling inlet i.

The heat exchange unit 32 specifically includes a heat exchanger 321 and a circulation pump group 322. A liquid inlet of the heat exchanger 321 is communicated with the cold liquid outlet h of the liquid storage tank 31, and the circulation pump group 322 is disposed between the cold liquid outlet h of the liquid storage tank 31 and the liquid inlet of the heat exchanger, and may be specifically disposed at the cold liquid outlet h, to provide power for flow of the coolant. A liquid outlet of the heat exchanger 321 is communicated with the liquid supply pipe 51. The circulation pump group 322 pumps the coolant in the liquid storage tank 31 into the heat exchanger 321. The heat exchanger 321 is connected to an external cooling water source. The external cooling water source flows through the heat exchanger 321, exchanges heat with the coolant in the heat exchanger 321, and takes away heat of the coolant to cool the coolant. The heat exchanger 321 may be connected to the liquid supply pipe 51, and the heat exchanger 321 may be connected to the liquid storage tank 31 through a pipe 33. The heat exchange unit 32 further includes a control board 323. The control board 323 may be specifically disposed on an inner wall of the structure of the heat exchange unit 32. The control board 323 is signally connected to the foregoing circulation pump group 322, and may control the circulation pump group 322. The control board 323 may be specifically a single-chip microcomputer, and an operation panel signally connected to the control board 323 may be disposed outside the heat exchange unit 32, to facilitate a control operation of a worker.

The circulation pump group 322 is set in a form of N+1, that is, there are N active circulation pumps and one standby pump. When an active circulation pump N is faulty, the standby pump may be started to ensure a normal liquid cooling cycle operation. The circulation pump group 322 is connected to the cold liquid outlet h of the liquid storage tank 31 by using a ball valve 6. When the circulation pump group 322 is faulty, the ball valve 6 may be directly closed, and the circulation pump group 322 is removed for maintenance and repair.

The liquid storage tank 31 is a tank structure. Specifically, a liquid storage cavity M and an operating cavity N that are distributed in a horizontal direction are formed in the tank structure. The liquid storage cavity M is separated from the operating cavity N, and liquid conduction can be implemented. The operating cavity N is communicated with the liquid supply pipe 51, coolant in the operating cavity N may be transferred to the liquid supply pipe 51, and the liquid return inlet g, the cold liquid outlet h, and the liquid filling inlet i on the liquid storage tank 31 are all communicated with the operating cavity N. The liquid return inlet g is located on a top of the operating cavity N, so that the coolant in the liquid return pipe 52 directly falls into the operating cavity N. The operating cavity N directly participates in liquid supply and liquid return operations of the liquid cooling circulation system, and the liquid storage cavity M is configured to provide storage and liquid refill functions for the operating cavity N. A function of liquid storage is as follows: When a quantity of coolant in the operating cavity N is large enough and exceeds a set maximum threshold, the coolant in the operating cavity N may flow into the liquid storage cavity M for storage. A function of liquid supplement is as follows: When a quantity of coolant in the operating cavity N is excessively small and is less than a specified minimum threshold, the coolant stored in the liquid storage cavity M may supplement coolant for the operating cavity N. Herein, the maximum threshold and the minimum threshold are defined as follows: The coolant in the operating cavity N can ensure that a liquid amount of the liquid cooling circulation system for implementing normal liquid cooling circulation is not greater than the maximum threshold and is not less than the minimum threshold. A running liquid level L0 is set for a liquid level of the coolant in the operating cavity N that works normally, a maximum threshold of the coolant corresponds to a liquid storage liquid level L1, and a minimum threshold of the coolant corresponds to a liquid refill liquid level L2. When the liquid cooling circulation system works normally, the running liquid level L0 needs to be greater than the liquid refill liquid level L2 and less than the liquid storage liquid level L1. Certainly, the running liquid level L0 may dynamically change when the liquid cooling circulation system works.

In this embodiment of this application, a sum of capacities of the liquid storage cavity M and the operating cavity N is set to accommodate at least coolant that flows back from all device nodes 1. Generally, coolant of the liquid cooling circulation system may evaporate and lose to a specific extent in an operating process, and specific coolant may also be lost during maintenance of the device node 1. To ensure normal operating of the liquid cooling circulation system, coolant amount not less than a specified threshold needs to be stored in the liquid storage cavity M, to meet a possible liquid filling requirement of the operating cavity N, and prevent a case in which coolant amount of the liquid cooling circulation system is insufficient. The specified threshold liquid amount corresponds to a safety liquid level L3. When the liquid level of the coolant in the liquid storage cavity M is lower than the safety liquid level L3, it indicates that the coolant amount of the liquid storage cavity M is insufficient to provide sufficient coolant when the operating cavity N needs to be filled with liquid. In this case, the coolant needs to be filled in the liquid storage tank 31 in time. To monitor a liquid amount of the coolant in the liquid storage cavity M, a first liquid level sensor 314 is disposed in the liquid storage cavity M, and an alarm is disposed in the first liquid level sensor 314. When the liquid level of the coolant in the liquid storage cavity M is lower than the safety liquid level L3, the first liquid level sensor 314 triggers an alarm, and reminds a worker to add liquid to the liquid storage tank 31 through the liquid filling inlet i.

To enable the coolant to flow between the liquid storage cavity M and the operating cavity N, a liquid-through channel needs to be formed between the liquid storage cavity M and the operating cavity N. For example, a partition plate 311 is disposed in the liquid storage tank 31, the partition plate 311 is disposed in a vertical direction, and the partition plate 311 may divide the liquid storage tank 31 into the liquid storage cavity M and the operating cavity N that are distributed in a horizontal direction. A gap q exists between a top of the partition plate 311 and an inner wall of the liquid storage tank 31, the gap q is equivalent to the foregoing liquid-through channel, and the coolant in the liquid storage cavity M and the coolant in the operating cavity N may implement liquid circulation and exchange by using the gap q. A condition for the coolant in the operating cavity N to flow to the liquid storage cavity M is that the coolant amount in the operating cavity N is sufficient. Therefore, a lowest point of the gap q may correspond to the liquid storage liquid level L1 of the coolant when the liquid amount in the operating cavity N reaches the maximum threshold. When the liquid level of the coolant in the operating cavity N is higher than the liquid storage liquid level L1, the coolant in the operating cavity N may overflow from the operating cavity N, the gap q between the top of the partition plate 311 and the inner wall of the liquid storage tank 31 may be used for circulation of the overflowed coolant, and no additional power support is required. The coolant in the liquid storage cavity M needs to be supplemented to the operating cavity N through power support. Specifically, a liquid refill pipe 312 may be disposed between the liquid storage cavity M and the operating cavity N, and a liquid refill pump 313 that can drive the coolant to transfer from a low potential energy to a high potential energy is disposed on the liquid refill pipe 312. Certainly, the liquid refill pump 313 may also be controlled by the control board 323 of the heat exchange unit 32.

When the running liquid level L0 of the coolant in the operating cavity N decreases to the liquid refill level L2 due to capacity expansion of the liquid cooling circulation system or other reasons, liquid needs to be refilled to the operating cavity N timely. To monitor a liquid level of the coolant in the operating cavity N, a second liquid level sensor 315 is disposed in the operating cavity N. The second liquid level sensor 315 is signally connected to the control board 323. The control board 323 receives liquid level information monitored by the second liquid level sensor 315, and controls, based on the liquid level information, the liquid refill pump 313 to press the coolant in the liquid storage cavity M to the operating cavity N through the liquid refill pipe 312, so that the liquid level of the coolant in the operating cavity N is restored to a normal operating liquid level.

It should be noted that, in this embodiment of this application, a main circulation pump of the circulation pump group 322 is a centrifugal pump. The circulation pump group 322 is connected to the operating cavity N by using a ball valve, and coolant working liquid level L0 in the operating cavity N needs to be higher than a pump body of the main circulation pump, to ensure that a rotor cavity of the main circulation pump is always below the coolant liquid level of the operating cavity N, and prevent air from entering the rotor cavity of the main circulation pump.

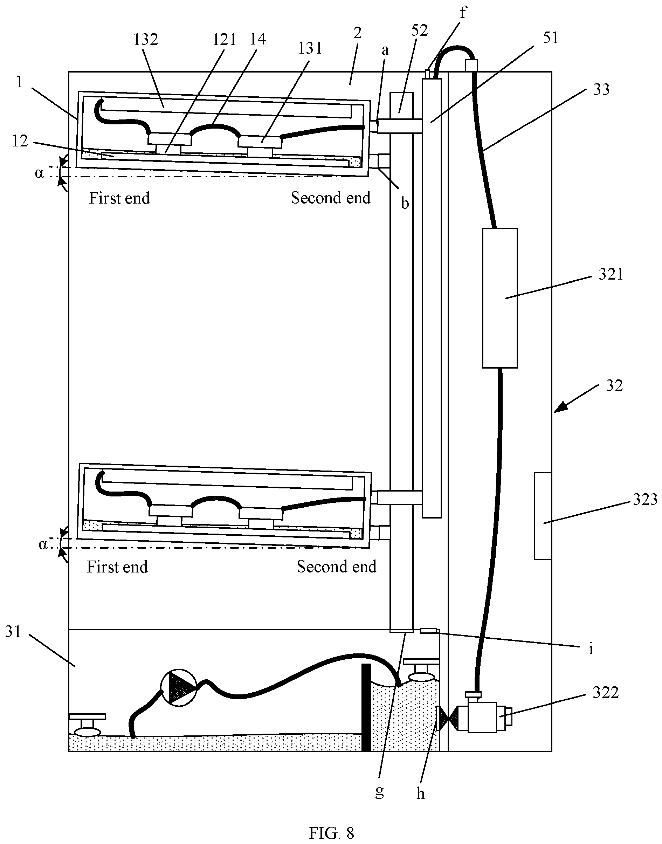

Still refer to FIG. 7. In this embodiment, at least one device node 1 is disposed along a vertical direction of a cabinet body 2 (two device nodes 1 are used as an example in the figure), and the device nodes 1 are stacked along the vertical direction of the cabinet body 2. In order to facilitate coolant in each device node 1 to be exported to a liquid return pipe 52, the device node 1 may be disposed in an inclined manner, so that the coolant in the device node 1 may flow from the first end to the second end under a gravity action, then, the liquid flows into the liquid return pipe 52 through a liquid return outlet b. Specifically, a structure of the device node 1 shown in FIG. 7 is used as an example. A housing 11 of the device node 1 is a regular shell structure, and a bottom of the housing 11 is a bottom surface with a uniform thickness. The device node 1 or the cabinet body 2 may be adjusted, so that a horizontal height of a first end of the device node 1 is higher than a horizontal height of a second end (as shown in FIG. 8), which is equivalent to that an included angle α exists between a connection line between the first end and the second end of the device node 1 and a horizontal plane, and an opening of the included angle α faces the first end. Finally, a lowest point of inner cavity space of the housing 11 of the device node 1 is equivalent to a side of the second end, the liquid return outlet b is located at the lowest point, and the coolant in the housing 11 of the device node 1 may accumulate to the second end under the gravity action and flow out to the liquid return pipe 52 through the liquid return outlet b.

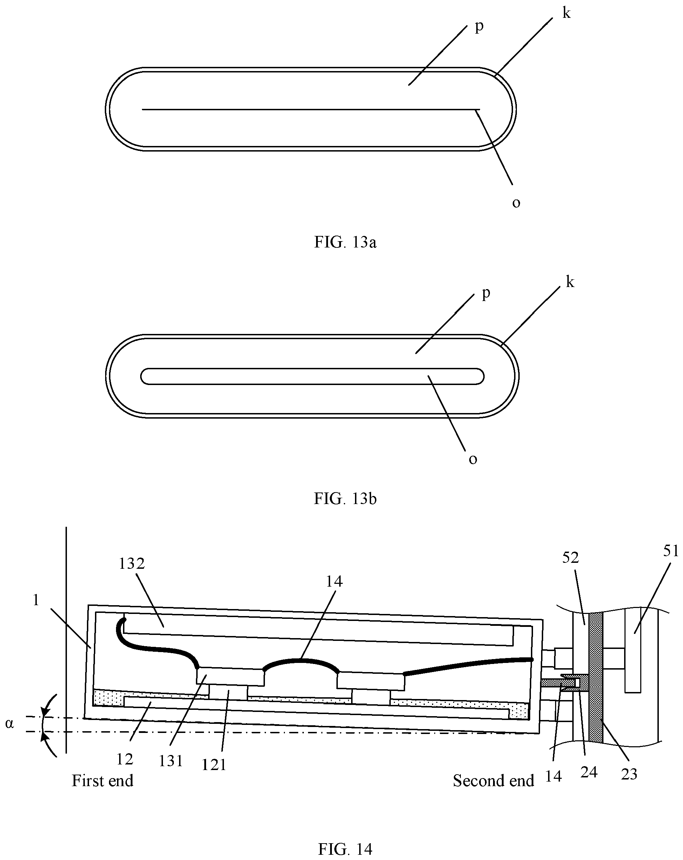

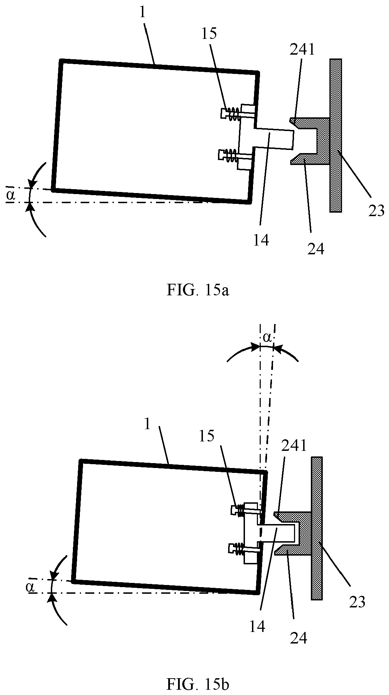

In an embodiment, as shown in FIG. 14, to enable the horizontal height of the first end of the device node 1 to be higher than the horizontal height of the second end, a guide rail with a gradient (not shown in the figure) may be disposed inside the cabinet body 2. In this way, after the device node 1 is inserted along the guide rail, an included angle α is formed between the device node 1 and a backplane 23 of the cabinet. FIG. 15a is a diagram of a structure of a device node 1 before being mounted in a cabinet. FIG. 15b is a diagram of a structure in which a device node 1 is mounted in a cabinet. The device node 1 is provided with a male connector 14. The male connector 14 located in the device node 1 may be designed as a floating structure, and a floating direction may include a moving direction relative to the backplane 23. In specific implementation, a device spring screw 15 may be used to ensure floatability. Correspondingly, a female connector 24 is disposed on the backplane 23, and the female connector 24 has a guide structure (for example, an inclined structure 241 shown in the figure). In an insertion process, the male connector 14 may be placed upright by the female connector 24 located on the backplane 23 by using the guide structure, to ensure reliable connection between the male connector 14 and the female connector 24. In this case, the male connector 14 and a rear window of the device node 1 form an included angle α (α in an upper right corner of the figure after insertion shown in FIG. 15b).

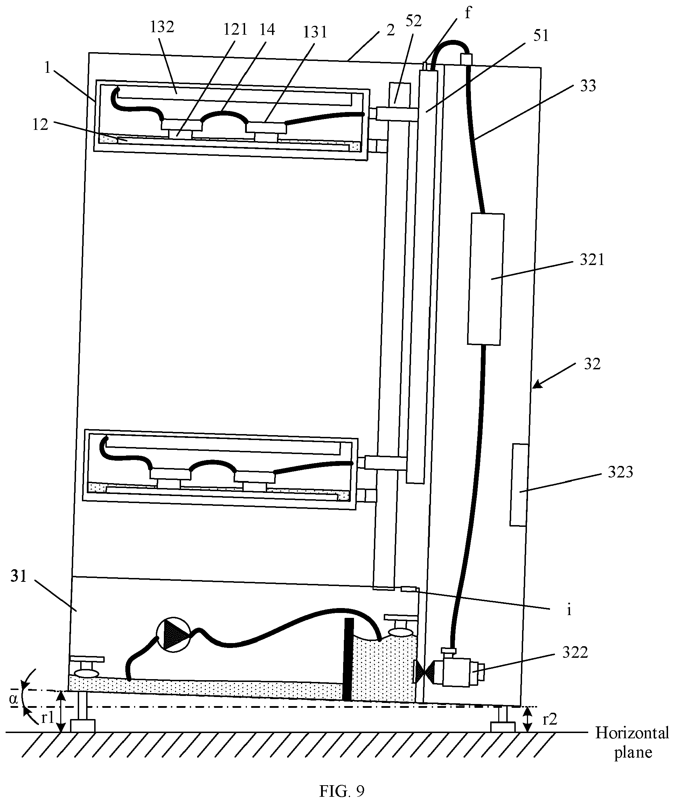

To achieve the foregoing objective, a mounting position of the device node 1 in the cabinet body 2 may be adjusted, that is, the cabinet body 2 is horizontally placed relative to a horizontal plane, and the device node 1 is tilted relative to the cabinet body 2, as shown in FIG. 8. Alternatively, as shown in FIG. 9, the device node 1 may be horizontally mounted in the cabinet body 2, the cabinet body 2 is adjusted, and a first foot 21 and a second foot 22 are disposed at a bottom of the cabinet body 2. The first foot 21 corresponds to the first end of the device node 1, the second foot 22 corresponds to the second end of the device node 1, and a height r1 of the first foot 21 is greater than a height r2 of the second foot 22, so that a horizontal plane on which the first end of the device node 1 is located is higher than a horizontal plane on which the second end is located, that is, the liquid return outlet b is located at a lowest point of the housing 11. It should be understood that a heat exchange unit 32 is integrated at a rear door of the cabinet body 2, and a liquid storage tank 31 is disposed at the bottom of the cabinet body 2. Therefore, in the simplified structural diagram shown in FIG. 9, the first foot 21 is equivalent to being located at the bottom of the liquid storage tank 31, and the second foot 22 is equivalent to being located at the bottom of the heat exchange unit 32. Finally, an included angle α exists between the bottom of the cabinet body 2 and the horizontal plane, and an opening of the included angle α faces a side of the first foot 21. Because the device node 1 is horizontally disposed relative to the cabinet body 2, the device node 1 also has an included angle α relative to the horizontal plane. According to a standard size of a liquid cooling cabinet, a height difference between the height r1 of the first foot 21 and the height r2 of the second foot 22 is greater than about 5 mm.

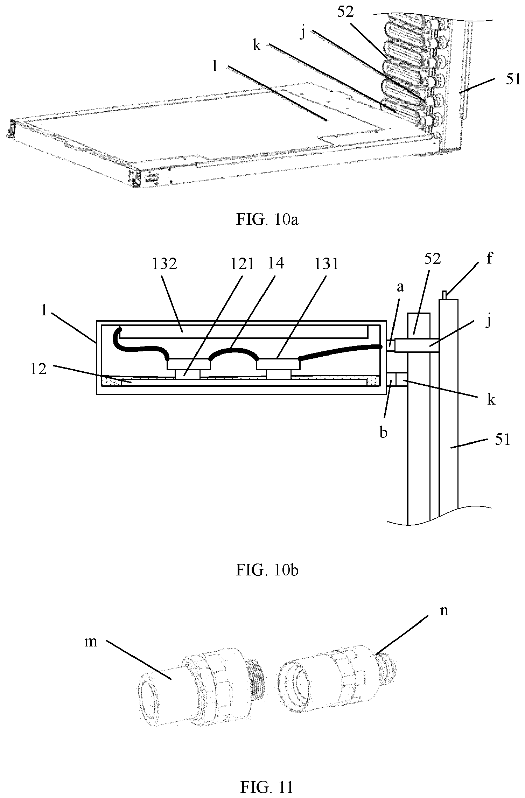

Structures of a liquid supply pipe 51 and a liquid return pipe 52 connected to the device node 1 are separately described. As shown in FIG. 10a, at least one liquid supply port j is formed on the liquid supply pipe 51, and each liquid supply port j corresponds to one device node 1; and at least one liquid return port k is formed on the liquid return pipe 52, and each liquid return port k corresponds to one device node 1.

A structure of the liquid supply pipe 51 and the liquid return pipe 52 connected to the device node 1 is simplified as shown in FIG. 10b. Each liquid supply port j is configured to correspondingly connect to a cold liquid inlet a of one device node 1. Coolant in the liquid supply pipe 51 may enter the corresponding device node 1 through each liquid supply port j and the cold liquid inlet a corresponding to the liquid supply port j, to ensure that coolant flow in each device node 1 is sufficient for liquid cooling, avoid uneven distribution of coolant.

Specifically, in the liquid supply port j and the cold liquid inlet a that are in a group and that correspond to each other, the liquid supply port j and the cold liquid inlet a may be quickly communicated and detached through a female connector m and a male connector n of a quick connector shown in FIG. 11. The female connector m may be disposed at the liquid supply port j, and correspondingly, the male connector n is disposed at the cold liquid inlet a; or the female connector m may be disposed at the cold liquid inlet a, and correspondingly, the male connector n is disposed at the liquid supply port j.

Still refer to FIG. 10b. Each liquid return port k is configured to correspondingly connect to a liquid return outlet b of one device node 1, and coolant in one device node 1 may enter a liquid return pipe 52 from the liquid return outlet b of the device node 1 and a liquid return port k corresponding to the liquid return outlet b, to ensure that coolant in each device node 1 can be discharged as soon as possible.

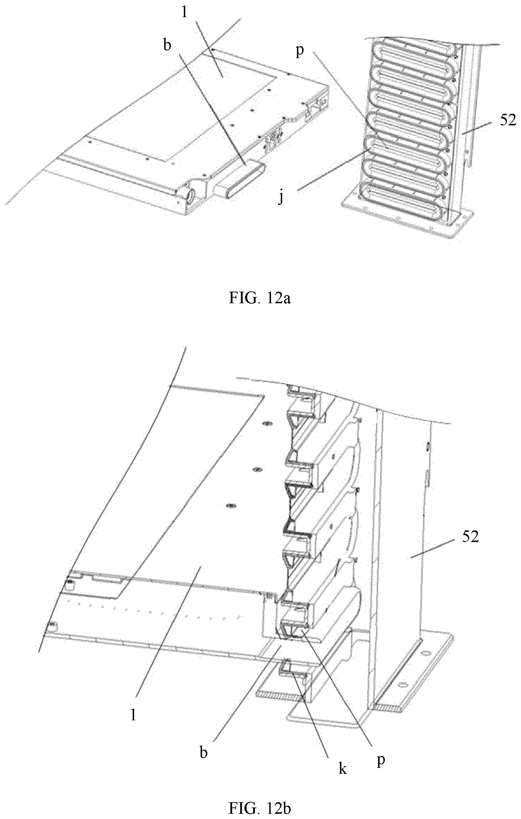

In a liquid return port k and a liquid return outlet b that are in a group and that correspond to each other, for structures of the liquid return ports k and the liquid return outlets b, refer to FIG. 12a. An inner diameter of the liquid return port k is greater than an outer diameter of the liquid return outlet b, so that the liquid return outlet b can be inserted into the liquid return port k. An elastic backflow prevention component p is disposed at the liquid return port k. When the liquid return outlet b is inserted into the liquid return port k as shown in FIG. 12b, the backflow prevention component p abuts against an outer wall of the liquid return outlet b, and the liquid return outlet b is communicated with the liquid return port k. When the liquid return outlet b is separated from the liquid return port k, the backflow prevention component p blocks the liquid return port k.

For a structure of the backflow prevention component p, refer to FIG. 13a and FIG. 13b. The backflow prevention component p is made of an elastic material (for example, rubber), and is disposed around an inner wall of the liquid return port k. A specific disposition manner may be that the backflow prevention component p is sleeved on the liquid return port k, or may be fastened to the inner wall of the liquid return port k through adhesion. In a non-stressed state, a central hole o of the backflow prevention component p is in a closed state as shown in FIG. 13a, so that the liquid return port k can be sealed in a radial direction. When the liquid return outlet b is inserted into the liquid return port k, the central hole o of an elastic backflow prevention component p is collided with the liquid return outlet b, as shown in FIG. 13b, so that the liquid return port k is in a through state. It should be understood that the backflow prevention component p may be of another structure, provided that the liquid return port k is closed when the liquid return outlet b is not inserted and is connected when the liquid return outlet b is inserted.

When the device node 1 needs to be disassembled for maintenance, after the device node 1 is pulled out for a distance of 15 mm from the liquid return port k, the liquid supply port j is disconnected from the cold liquid inlet a, and liquid flow between the liquid supply port j and the cold liquid inlet a is directly stopped, that is, the coolant in the liquid supply pipe 51 is not transferred to the device node 1. However, the coolant of the device node 1 further needs to flow into the liquid return pipe 52. A radial sealing structure of the backflow prevention component p for the liquid return port k may provide specific time for the coolant in the device node 1 to flow back to the liquid return pipe 52. After the device node 1 is placed for a period of time, the coolant in the device node 1 completely flows into the liquid return pipe 52, and then the device node 1 is completely pulled out for maintenance.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A device node, comprising a housing, a circuit board, and a heat dissipation component, wherein
the housing has a cold liquid inlet and a liquid return outlet, both the circuit board and the heat dissipation component are disposed in the housing, and at least one main chip is disposed on the circuit board;
the heat dissipation component comprises a spray plate and at least one liquid cold plate, the at least one liquid cold plate is in a one-to-one correspondence with the at least one main chip, each liquid cold plate is in contact with a corresponding main chip to perform liquid cooling heat dissipation on the corresponding main chip, each liquid cold plate is configured to form a liquid cooling channel, liquid cooling channels of the at least one liquid cold plate are communicated to form a liquid cooling network, and an inlet of the liquid cooling network is communicated with the cold liquid inlet; and
the spray plate has a spray channel communicated with an outlet of the liquid cooling network and a plurality of liquid spray holes communicated with the spray channel, and a liquid outlet end of each of the liquid spray holes faces the circuit board.

2. The device node according to claim 1, wherein a surface that is of the spray plate and that faces the circuit board comprises a first area and a second area, the first area corresponds to the at least one main chip, and the plurality of liquid spray holes are located in the second area.

3. The device node according to claim 1 or 2, wherein when coolant flows into the device node, a liquid level of the coolant in the housing is 1 mm to 3 mm higher than a highest position on a surface of the circuit board.

4. The device node according to any one of claims 1 to 3, wherein the liquid cold plate comprises a plate body fastened to the circuit board, and the liquid cooling channel is formed between the plate body and the circuit board; and
the liquid cooling channel comprises a first liquid cooling cavity communicated with the cold liquid inlet and a second liquid cooling cavity communicated with the spray channel, the main chip is located in the second liquid cooling cavity, a jet plate is disposed between the first liquid cooling cavity and the second liquid cooling cavity, the jet plate has a jet hole that communicates with the first liquid cooling cavity and the second liquid cooling cavity, and the jet hole is configured to spray coolant in the first liquid cooling cavity to the main chip.

5. The device node according to any one of claims 1 to 3, wherein the at least one liquid cold plate is connected in series and/or in parallel.

6. The device node according to any one of claims 1 to 5, wherein the liquid return outlet is located at a lowest position of the housing.

7. A liquid cooling cabinet, comprising a cabinet body, a circulation liquid cooling system, and at least one device node according to any one of claims 1 to 6, wherein
the at least one device node is disposed in the cabinet body, the circulation liquid cooling system is sealedly connected to a cold liquid inlet of each device node through a liquid supply pipe, the circulation liquid cooling system is sealedly connected to a liquid return outlet of each device node through a liquid return pipe, and an air intake vent communicated with an atmosphere is provided on a top of the liquid return pipe.

8. The liquid cooling cabinet according to claim 7, wherein the circulation liquid cooling system comprises a liquid storage tank and a heat exchange unit;
the liquid storage tank is disposed inside the cabinet body and is located at a bottom of the cabinet body, the liquid storage tank has a liquid return inlet and a cold liquid outlet, the liquid return inlet is communicated with the liquid return pipe, and the cold liquid outlet is communicated with the liquid supply pipe; and
the heat exchange unit is integrated behind the cabinet body, and the heat exchange unit is connected between the cold liquid outlet and the liquid supply pipe.

9. The liquid cooling cabinet according to claim 8, wherein the liquid storage tank has a liquid storage cavity and an operating cavity that are separated, and both the liquid return inlet and the cold liquid outlet are communicated with the operating cavity; and
a liquid-through channel is formed between the liquid storage cavity and the operating cavity.

10. The liquid cooling cabinet according to claim 9, wherein a partition plate is disposed in the liquid storage tank, the partition plate separates the liquid storage tank into the liquid storage cavity and the operating cavity, a gap exists between a top of the partition plate and an inner wall of the liquid storage tank to form the liquid-through channel, and the liquid storage cavity and the operating cavity are communicated through a liquid refill pipe.

11. The liquid cooling cabinet according to claim 10, wherein a liquid refill pump is disposed on the liquid refill pipe, and the heat exchange unit is signally connected to the liquid refill pump.

12. The liquid cooling cabinet according to any one of claims 9 to 11, wherein a first liquid level sensor is disposed in the liquid storage cavity, and the first liquid level sensor has an alarm; and
a second liquid level sensor is disposed in the operating cavity, and the second liquid level sensor is signally connected to the heat exchange unit.

13. The liquid cooling cabinet according to any one of claims 8 to 12, wherein the heat exchange unit comprises a control board, a heat exchanger, and a circulation pump group, and the control board is signally connected to the circulation pump group; and
a liquid inlet of the heat exchanger is communicated with the liquid return outlet, a liquid outlet of the heat exchanger is communicated with the liquid supply pipe, and the circulation pump group is disposed between the liquid return outlet and the liquid inlet.

14. The liquid cooling cabinet according to any one of claims 7 to 13, wherein at least one liquid supply port is formed on the liquid supply pipe, and each liquid supply port is configured to correspondingly connect to a cold liquid inlet of one device node; and
in the liquid supply port and the cold liquid inlet that are in a group and that correspond to each other, the liquid supply port and the cold liquid inlet are connected through a quick connector.

15. The liquid cooling cabinet according to any one of claims 7 to 14, wherein at least one liquid return port is formed on the liquid return pipe, and each liquid return port is configured to correspondingly connect to a liquid return outlet of one device node;
in the liquid return port and the liquid return outlet that are in a group and that correspond to each other, an inner diameter of the liquid return port is greater than an outer diameter of the liquid return outlet, so that the liquid return outlet is inserted into the liquid return port; and
an elastic backflow prevention component is disposed at the liquid return port, when the liquid return outlet is inserted into the liquid return port, the backflow prevention component abuts against an outer wall of the liquid return outlet, and when the liquid return outlet is separated from the liquid return port, the backflow prevention component radially blocks the liquid return port.

16. The liquid cooling cabinet according to any one of claims 7 to 15, wherein for each device node, a housing has a first end and a second end that are opposite to each other, and the liquid return outlet is located at the second end; and
a first foot corresponding to the first end and a second foot corresponding to the second end are provided at the bottom of the cabinet body, and a height of the first foot is greater than a height of the second foot.

17. The liquid cooling cabinet according to any one of claims 7 to 16, wherein the at least one device node is stacked in a vertical direction.
